Europäisches Patentamt

European Patent Office

Office européen des brevets

(19)

(11) Publication number: **0 308 969**
**A2**

(12) # EUROPEAN PATENT APPLICATION

(21) Application number: **88115729.1**

(22) Date of filing: **23.09.88**

(51) Int. Cl.⁴: **H01L 29/76**

(30) Priority: **25.09.87 US 101107**

(43) Date of publication of application:
**29.03.89 Bulletin 89/13**

(84) Designated Contracting States:
**DE ES FR GB IT**

(71) Applicant: **Siemens Aktiengesellschaft Berlin
und München
Wittelsbacherplatz 2
D-8000 München 2(DE)**

(72) Inventor: **Kohn, Erhard, Dr.
6 State Park Drive
Titusville, NJ 08560(US)**
Inventor: **Wu, Chia-Jen
51 Jurocko Avenue
Somerset, NJ 08873(US)**
Inventor: **Lee, Hao
14 Cedar Court
Princeton Junction, NJ 08550(US)**

(54) **High electron mobility transistor structure.**

(57) A high electron mobility field effect transistor
includes an undoped gallium arsenide first layer. An
n-doped gallium arsenide second layer is formed
over the first layer. A third n-doped transition layer
formed over the second layer is of aluminum gallium
arsenide next the second layer and has a graded
aluminum content gradually decreasing such that the
top of the third layer is gallium arsenide. A gate
electrode Schottky barrier junction is formed over
the third layer. Source and drain n-doped regions
are also formed over the third layer.

EP 0 308 969 A2

FIG 2

The present invention relates to field effect transistors and more particularly to high electron mobility field effect transistors (HEMT FET).

Field effect transistors (FET's) using gallium arsenide (GaAs) are known to be capable of high speed operation. Devices using gallium arsenide/aluminum gallium arsenide (GaAs/AlGaAs) heterostructures form a two-dimensional electron gas (2DEG). In such devices the donor impurities are confined away from the active channel in which electrons may flow. This separation of donor impurities from the electron layers causes the device to exhibit extremely high electron mobilities and thereby to be capable of extremely fast operation, for example, in high speed switching.

In a typical HEMT arrangement, a semi-insulating GaAs substrate has formed over it an undoped GaAs buffer layer. Above this is generally an N-doped AlGaAs layer, typically 300 Å to 500 Å thick, which serves as an electron donor layer for forming 2DEG active channel in the undoped GaAs buffer layer beneath it. The donor layer may be separated from the undoped GaAs buffer by a thin intermediate spacer layer of undoped AlGaAs which is typically 15 Å to 50 Å thick and which serves to further separate the active channel electrons from the dopant atoms of the N-doped AlGaAs layer. The actual thickness of the spacer layer may be selected in a trade-off in which a thicker layer leads to increased mobility but lowers electron densities in the active channel compared with a thinner layer. A gate electrode is generally formed as a Schottky barrier electrode on the AlGaAs donor layer with the source and drain electrodes disposed on opposite sides of the gate electrode. The gate electrode is generally formed in a recess in the case of high performance FET's, e.g. for use at microwave frequencies. This allows parasitic capacitances and series resistances to be kept very small.

However, the presence of AlGaAs in the device structure results in a number of difficulties,when the gate recess reaches into the AlGaAs layer, as has been described. Differences in etching behavior of AlGaAs and GaAs need to be taken into account in forming the recess. Furthermore, a lack of stability of the AlGaAs surface during processing is a significant factor affecting the resulting device. When the Schottky barrier is being formed by the deposition of metal, problems result because the surface prepared to receive it tends to form additional aluminum oxide during the etching process.

Additionally, the resulting device, having a gate electrode formed in the AlGaAs layer will tend to exhibit instability of its performance characteristics at elevated temperatures, believed to be due to the influence of interfacial oxide films, metal reaction, and interdiffusion on the Schottky barrier characteristics. Such instability takes place at temperatures significantly lower than is the case for a gate electrode formed on GaAs.

The behavior of the ohmic contacts needed for the source and drain electrodes is also subject to problems of alloying in the presence of aluminum, particularly so in the case of AuGe based ohmic contacts.

The foregoing problems are generally aggravated by the need to utilize a high aspect ratio of channel length to vertical gate-channel separation for high performance. The entire AlGaAs system in an advanced HEMT device accordingly needs to be compressed into an undesirably a small dimension, e.g. 250 Angstroms or less when a gate of 0.25 micrometers or less is used.

In accordance with an aspect of the invention a high electron mobility field effect transistor comprises a first substantially undoped semiconductor layer of gallium arsenide and a second semiconductor layer of aluminum gallium arsenide of a first conductivity type, formed over the first semiconductor layer. A third semiconductor layer of the first conductivity type having first and second sides is formed over the second semiconductor layer so as to form an interface therewith at the first side, the third semiconductor layer being of aluminum gallium arsenide (AlGaAs) in a portion thereof adjacent the interface and having a graded aluminum content decreasing along a thickness dimension of the third semiconductor layer in a direction away from the interface. A conductive gate is formed on the second side of the third semiconductor layer.

In accordance with another aspect of the invention, the aluminum content decreases along the thickness dimension substantially in accordance with a law of exponential decay. In accordance with yet another aspect of the invention, the aluminum content is substantially zero at the side of the third semiconductor layer opposite the interface.

In accordance with still another aspect of the invention, the high electron mobility field effect transistor includes a fifth semiconductor layer intermediate the first and second layer, the fifth semiconductor layer being relatively thin compared with the second semiconductor layer and being of aluminum gallium arsenide and substantially undoped.

In accordance with a further aspect of the invention, the gate electrode means comprises a metal gate electrode forming a Schottky barrier with the third semiconductor layer.

The invention will next be described in greater detail with reference to the drawing, in which

FIG. 1 shows a cross-sectional view, not to scale, of a field effect transistor in accordance with the invention; and

FIG. 2 shows a cross-sectional view, not to scale, of another field effect transistor in accordance with the invention. Features in FIG. 2 corresponding to features in FIG. 1 are designated by the same reference numeral.

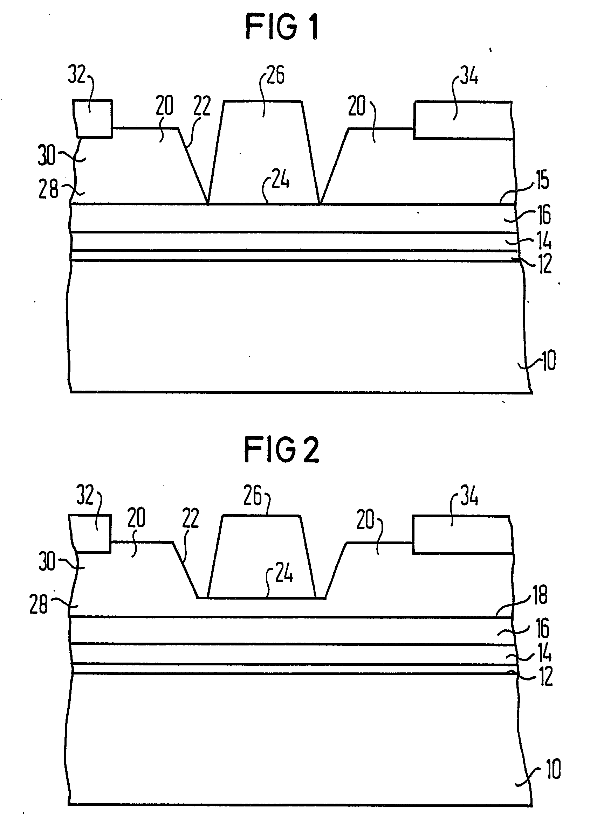

In the transistor structure of FIG. 1, 10 is a gallium arsenide layer (GaAs) which is substantially undoped and is generally referred to as a buffer layer. Buffer layer 10 may be formed over a semi-insulating GaAs substrate, not shown in either of FIGS. 1 and 2. A relatively thin layer 12 of substantially undoped aluminum gallium arsenide (AlGaAs) is formed over buffer layer 10. Layer 12 is generally referred to as a spacer layer and its thickness is generally selected in a trade-off between electron mobility and electron density as was previously mentioned in the introductory part of the specification. However, spacer layer 12 is not essentially required, or it may be as thin as a monoatomic layer.

Formed over spacer layer 12 is a relatively highly n-doped AlGaAs layer 14, referred to as a spike- or pulse-doped layer. Layer 14 acts as a donor to establish a two-dimensional electron gas (2DEG) in buffer layer 10.

A transition layer 16 is formed over layer 14. Transition layer 16 is of AlGaAs in the region adjacent layer 14. However, the concentration of aluminum decreases as the distance from the interface with layer 14 increases. The decrease is gradual, so that the concentration of aluminum drops to a low value, approaching zero near the top surface 18 of transition layer 16 which is therefore substantially of GaAs. Transition layer 16 is n-doped, but at a lower concentration than layer 14.

A cap layer of GaAs 20 is formed over transition layer 16. Cap layer 20 has therein a recess or hole 22 having sides reaching down to the top surface of transition layer 16 such that a portion 24 of the top surface is not covered by cap layer 20.

A metal gate electrode 26 is formed in the recess 22 on surface portion 24 so as to form a Schottky barrier junction with transition layer 16.

Cap layer 20 is n-doped at a relatively low concentration in region 28 proximate to transition layer 16 and at a relatively high concentration in a region 30 proximate its upper surface. A source electrode 32 and a drain electrode 34 are formed on opposite sides of recess 22 in respective portions of cap layer 20 having a relatively high doping concentration, and consequently having relatively high conductivity.

As a result of the grading of the aluminum conentration in transition layer 16, the Schottky barrier junction under gate 26 is formed between metal and GaAs. The technology and stability of such junctions are well understood and are such that the aforementioned problems of a Schottky junction involving aluminum are prevented. There is thus no problem of AlGaAs oxidation accompanying etching of recess 22 and the Schottky barrier is closer to being ideal and exhibits less parasitic leakage. Furthermore, in view of the gradual increase in aluminum concentration in transition layer 16 in a downward direction, there is no abrupt transition from GaAs to AlGaAs. A grading profile is selected so that the aluminum concentration drops or decays exponentially as the distance increases from the bottom to the top side of transition layer 16. This grading profile is selected to avoid a second conduction band discontinuity above the 2DEG interface, the first discontinuity being that between AlGaAs spacer layer 12 and GaAs buffer 10 which creates the potential well in which the 2DEG is formed to provide the active conduction region in buffer layer 10, controlled by the potential in gate 20. The occurrence of such a second conduction band discontinuity leads to an undesired diversion of electrons provided by the donor layer 14 away from the active 2DEG region where they are needed for transistor operation. Tunnelling for ohmic contact behavior and charge transfer efficiency into the 2DEG are accordingly enhanced by the aluminum concentration grading in transition layer 16 in accordance with the present invention, thus providing a transistor with higher mutual conductance.

The top side of transition layer 16, which is essentially GaAs, provides a smooth transition to cap layer 20 without any substantial band-gap discontinuity. Consequently the path between each of source contact 32 and drain contact 34 to the respective channel ends exhibits low resistance, as is preferred in the transistor.

FIG. 2 shows an alternative embodiment of the invention in which recess 22 does not reach the top side of transition layer 16 but leaves a relatively thin layer of cap layer 20 interposed between gate electrode 26 and transition layer 16. As has been explained, cap layer 20 is GaAs and has a relatively low doping level in region 28 proximate the top side of transition layer 16. The Schottky barrier junction in this embodiment is consequently also free of AlGaAs Schottky barrier junction problems. Since transition layer 16 in the FIG. 2 embodiment is similarly graded to that in the FIG. 1 embodiment, similar considerations apply to the FIG. 2 embodiment with regard to the problems overcome thereby.

The invention has been described by way of exemplary embodiments. It will be understood by those skilled in the art that various modifications may be introduced without departing from the scope of the invention as defined by the claims following. For example, the aluminum concentration in transition layer 16 may follow a grading profile other than an exponential decay function, for example, the Error function or a Gaussian function or another gradual law of change. For another example, spacer layer 22 may be omitted.

## Claims

1. A high electron mobility field effect transistor comprising:
a first semiconductor layer being substantially undoped gallium arsenide;
a second semiconductor layer of aluminum gallium arsenide of a first conductivity type, formed over said first semiconductor layer;
a third semiconductor layer of said first conductivity type having first and second sides and being formed over said second semiconductor layer so as to form an interface therewith at said first side said third semiconductor layer being of aluminum gallium arsenide (AlGaAs) in a portion thereof adjacent said interface and having a graded aluminum content decreasing along a thickness dimension of said third semiconductor layer in a direction away from said interface; and
conductive gate means formed on said second side of said third semiconductor layer.

2. A high electron mobility field effect transistor as recited in Claim 1, wherein said aluminum content decreases substantially in accordance with a law of exponential decay.

3. A high electron mobility field effect transitor as recited in Claim 1 wherein said aluminum content is substantially zero at said second side of said third semiconductor layer, opposite said interface.

4. A high electron mobility field effect transistor as recited in Claim 3, wherein said aluminum content decreases substantially in accordance with a law of exponential decay.

5. A high electron mobility field effect transistor as recited in Claim 1, further including a fourth semiconductor layer intermediate said first and second layer, said fourth semiconductor layer being relatively thin compared with said second semiconductor layer and being of aluminum gallium arsenide and substantially undoped.

6. A high electron mobility field effect transistor as recited in Claim 1 wherein said gate electrode means comprises a metal gate electrode forming a Schottky barrier with said third semiconductor layer.

7. A high electron mobility field effect transistor as recited in Claim 2 wherein said gate electrode means comprises a metal gate electrode forming a Schottky barrier with said third semiconductor layer.

8. A high electron mobility field effect transistor as recited in Claim 3 wherein said gate electrode means comprises a metal gate electrode forming a Schottky barrier with said third semiconductor layer.

9. A high electron mobility field effect transistor as recited in Claim 4 wherein said gate electrode means comprises a metal gate electrode forming a Schottky barrier with said third semiconductor layer.

10. A high electron mobility field effect transistor as recited in Claim 5 wherein said gate electrode means comprises a metal gate electrode forming a Schottky barrier with said third semiconductor layer.

11. A high electron mobility field effect transistor in accordance with Claim 1 including a fourth semiconductor layer of gallium arsenide of said first conductivity type formed over said third semiconductor layer.

12. A high electron mobility field effect transistor as recited in Claim 11, wherein said gate electrode means comprises a metal gate electrode and wherein at least a relatively thin portion of said fourth semiconductor layer extends over said third semiconductor layer under said metal gate electrode for forming a Schottky barrier therewith.

13. A high electron mobility field effect transistor as recited in Claim 12, wherein said aluminum content decreases substantially in accordance with a law of exponential decay.

14. A high electron mobility field effect transistor as recited in Claim 12, wherein said aluminum content is substantially zero at said second side of said third semiconductor layer, opposite said interface.

15. A high electron mobility field effect transistor as recited in Claim 14, wherein said aluminum content decreases substantially in accordance with a law of exponential decay.

16. A high electron mobility field effect transistor comprising:
a first semiconductor layer of gallium arsenide and being subsantially undoped;
a second semiconductor layer of aluminum gallium arsenide being substantially undoped and forming a first interface with said first semiconductor layer;
a third semiconductor layer of aluminum gallium arsenide of a predetermined conductivity type forming a second interface with said second semiconductor layer;
a fourth semiconductor layer having a first side forming a third interface with said third semiconductor layer and having a second side, said fourth semiconductor layer being of said predetermined conductivity type and being of aluminum gallium arsenide at said first side and having an aluminum content decreasing in a direction away from said first side and toward said second side; and
gate electrode means formed on said second side of said fourth semiconductor layer.

17. A high electron mobility field effect transistor as recited in Claim 16 wherein said aluminum content decreases gradually from said first side to substantially zero at said second side.

18. A high electron mobility field effect transistor as recited in Claim 16 wherein said aluminum content decreases substantially in accordance with a law of exponentially decay substantially to zero at said second side.

19. A high electron mobility field effect transistor as recited in Claim 16 including a fifth semiconductor layer of said predetermined conductivity type and having therein a recess accommodating said gate electrode means, said fifth semiconductor layer providing source and drain contacts.

20. A high electron mobility field effect transistor comprising:
a first semiconductor layer of gallium arsenide and being subsantially undoped;
a second semiconductor layer of aluminum gallium arsenide being substantially undoped and forming a first interface with said first semiconductor layer;
a third semiconductor layer of aluminum gallium arsenide of a predetermined conductivity type forming a second interface with said second semiconductor layer;
a fourth semiconductor layer having a first side forming a third interface with said third semiconductor layer and having a second side, said fourth semiconductor layer being of said predetermined conductivity type and being. of aluminum gallium arsenide at said first side and having an aluminum content decreasing in a direction away from first side and toward said second side;
a fifth semiconductor layer of gallium arsenide of said predetermined conductivity type being formed over said fourth semiconductor layer and having therein a recess reaching to said fourth semiconductor layer, said fifth semiconductor layer having a relatively low conductivity proximate said fourth semiconductor layer and having a relatively high conductivity distal from said fourth semiconductor layer;
source and drain electrode means formed in respective high conductivity portions of said fifth semiconductor layer on opposite sides of said recess; and
gate electrode means formed in said recess on said fourth semiconductor layer.

21. A high electron mobility field effect transistor as recited in Claim 20 wherein said aluminum content decreases in accordance with a law of exponential decay.

22. A high electron mobility field effect transistor as recited in Claim 21 wherein said aluminum content is substantially zero at said second side.

23. A high electron mobility field effect transistor comprising:
a first semiconductor layer of gallium arsenide and being subsantially undoped;
a second semiconductor layer of aluminum gallium arsenide being substantially undoped and forming a first interface with said first semiconductor layer;
a third semiconductor layer of aluminum gallium arsenide of a predetermined conductivity type forming a second interface with said second semiconductor layer;
a fourth semiconductor layer having a first side forming a third interface with said third semiconductor layer and having a second side, said fourth semiconductor layer being of said predetermined conductivity type and being of aluminum gallium arsenide at said first side and having an aluminum content decreasing in a direction away from first side and toward said second side;
a fifth semiconductor layer of gallium arsenide of said predetermined conductivity type being formed over said fourth semiconductor layer and having therein a recess not reaching to said fourth semiconductor layer, said fifth semiconductor layer having a relatively low conductivity proximate said fourth semiconductor and having a relatively high conductivity distal from said fourth semiconductor layer;
source and drain electrode means formed in respective high conductivity portions of said fifth semiconductor layer on opposite sides of said recess; and
gate electrode means formed in said recess on a portion of said fifth semiconductor layer forming a bottom of said recess.

24. A high electron mobility field effect transistor as recited in Claim 23 wherein said aluminum content decreases in accordance with a law of exponential decay.

25. A high electron mobility field effect transistor as recited in Claim 24 wherein said aluminum content is substantially zero at said second side.

## FIG 1

## FIG 2